# DEMANDE DE BREVET EUROPEEN

(11) **EP 0 780 497 A1**
(43) Date de publication de la demande: **25.06.1997**
(21) Numéro de dépôt: 96402794.0
(22) Date de dépôt: 18.12.1996
(51) Int. Cl.: C30B 7/00, C30B 29/58, C30B 30/08

(54) **Procédé et dispositif d'élaboration de cristaux par sustentation sur film de gaz**

(30) Priorité: 20.12.1995 FR 9515161
(71) Demandeur: COMMISSARIAT A L'ENERGIE ATOMIQUE, 75015 Paris Cédex 15 (FR)
(72) Inventeur: Parayre, Claude, 38320 Poisat (FR); Bancillon, Jacky, 38120 Saint Egreve (FR); Kernevez, Nelly, 38700 Corenc (FR); Fontecilla, Juan, 38920 Crolles (FR)
(74) Mandataire: Dubois-Chabert, Guy

(57) **Abrégé**

L'invention concerne un procédé d'élaboration de cristaux par sustentation sur film de gaz ainsi qu'un dispositif pour la mise en oeuvre de ce procédé. Le but de l'invention est essentiellement d'obtenir des cristaux présentant une taille, une forme et une qualité suffisantes, afin notamment de permettre l'étude de leurs structure. Ce but est atteint, selon l'invention par un procédé d'élaboration d'au moins un cristal caractérisé en ce que ledit cristal est élaboré dans un milieu tel qu'une goutte de solution mis en sustentation sur un film de gaz.

Le procédé peut être notamment appliqué à l'étude de la structure de molécules organiques et/ou biologiques ou peut être utilisé comme technique séparative par cristallisation fractionnée.

## Description

La présente invention a pour objet un procédé et un dispositif d'élaboration de cristaux et en particulier de cristaux organiques et/ou biologiques par sustentation sur film de gaz.

Il est nécessaire, dans le cadre notamment de la détermination de la structure tridimensionnelle des macromolécules biologiques et/ou organiques par des méthodes d'analyse diffractométriques telles que rayons X, neutrons... de parvenir à faire croître des cristaux de taille, de forme et de qualité suffisantes.

Les méthodes courantes de cristallogénèse des molécules biologiques et/ou organiques et en particulier des protéines sont décrites de manière détaillée dans le document de DUCRUIX A., GIEGE R "Crystallisation of Nucleic Acids and Proteins. A practical approach", chapter 4, "Methods of crystallization", p. 73-98. The practical approach series. IRL Press, (Oxford University Press), 1992.

Toutes ces méthodes ont en commun le fait que l'on cherche à amener la solution de molécules ou de macromolécules biologiques dans un état de sursaturation, en effet, pour qu'il y ait croissance des cristaux, il faut d'une part que la limite de solubilité soit dépassée, c'est-à-dire qu'il y ait sursaturation : c'est l'aspect thermodynamique ; il faut ensuite que le temps de latence, c'est-à-dire le temps d'apparition des cristaux, ne soit pas trop long : c'est l'aspect cinétique. Le phénomène de nucléation est la création des premiers germes solides appelés "nucléi", c'est-à-dire germes, dans une solution sursaturée ; c'est la première étape de la formation d'une nouvelle phase cristallisée. On distingue deux sortes de nucléation, la nucléation homogène et la nucléation hétérogène. La nucléation est dite homogène lorsqu'il y a formation de nucléi exclusivement entre les espèces et les ions libres en solution ; la nucléation est dite hétérogène lorsqu'il y a formation de nucléi au contact d'une interface telle que parois, cristaux déjà formés, poussières, etc.

L'interface peut participer aux échanges énergétiques, ce qui a généralement pour effet de diminuer l'enthalpie libre de formation d'un germe.

Il existe une taille critique en dessous de laquelle un nucleus est instable et tendra à se redissoudre. Au-delà, le nucleus pourra croître. Ceci correspond donc à une sursaturation à dépasser pour avoir une nucléation. C'est ce qu'on appelle zone de métastabilité. Le temps de latence appelé aussi temps de germination est le temps nécessaire pour qu'un nombre suffisant de molécules se rassemblent et s'assemblent pour former des germes élémentaires stables (nucléi) .

Lorsque les embryons ont atteint la taille du nucleus critique, la croissance cristalline a lieu puisque la solution sursaturée tend vers l'état d'équilibre par précipitation.

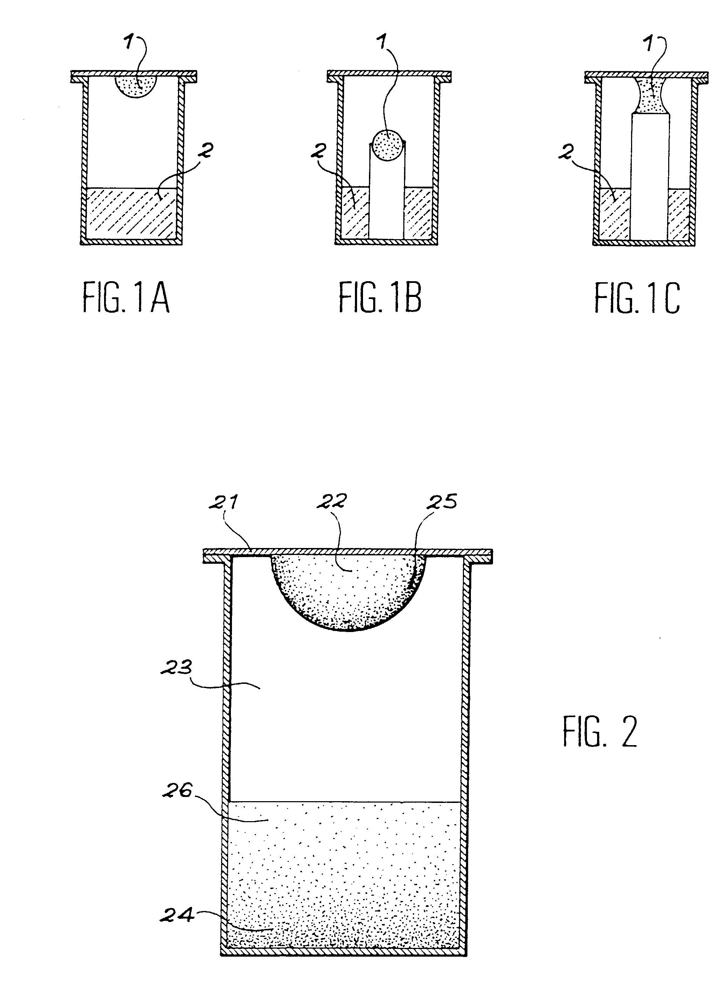

Les procédés de cristallogénèse basés sur le principe ci-dessus, peuvent donc être classés en deux grandes catégories : à savoir d'une part les procédés avec contact, d'autre part les procédés sans contact. Les procédés avec contact comprennent par exemple les procédés de cristallisation par dialyse, notamment par double dialyse et les procédés de cristallisation par diffusion de vapeur. Ces derniers procédés sont parmi les procédés les plus utilisés, ils ont été par exemple utilisés pour la première fois pour la cristallisation de l'ARNt et comprennent la cristallisation en goutte suspendue, la cristallisation en goutte posée et la cristallisation en goutte sandwich qui sont représentées respectivement sur les figures 1A, 1B, 1C dans lesquelles les solutions de macromolécule (1) et les réservoirs d'agent précipitant (2) sont indiqués.

Parmi ces variantes du procédé de cristallisation par diffusion de vapeur, le plus répandu que nous prenons comme référence ci-dessous est le procédé qui est schématisé sur la Figure 2, il s'agit du procédé de cristallisation en goutte suspendue, encore dénommé "hanging drop method" dans les ouvrages en langue anglaise.

Le schéma de fonctionnement de ce procédé est le suivant, il est indiqué sur les figures lA et 2.

La goutte suspendue (22) au couvercle (21) du récipient contient par exemple une macromolécule biologique telle qu'une protéine en solution, un tampon de réglage du pH, un agent précipitant à une concentration initiale Cᵢ. Le récipient contient par ailleurs dans sa partie réservoir (24) une solution du même agent précipitant à une concentration Cᵣ. Le réservoir et la goutte sont séparés par un espace rempli d'air (23) . Le volume de solution dans le réservoir est très supérieur à celui de la goutte de telle sorte que Cᵣ reste constant pendant toute la durée de la cristallisation. FOWLIS W.W., De LUCAS L.J. dans "Experimental and theoretical analysis of the rate of solvent equilibration in the hanging drop method of protein crystal growth" ; Second International. Conf. Strasbourg, France, July 1987 ; Journal of Crystal Growth. Vol. 90, (1988) n° 1-3, pp. 117-129 ont montré que la diffusion moléculaire contrôle le processus. La tension de vapeur d'eau à la surface (25) de la goutte est supérieure à celle régnant à la surface de la solution (26) dans le réservoir. Il y a donc transfert d'eau dans le sens de la goutte vers le réservoir. La concentration en sel précipitant augmente donc progressivement au cours du temps. La température est maintenue constante pendant toute la durée de l'expérience.

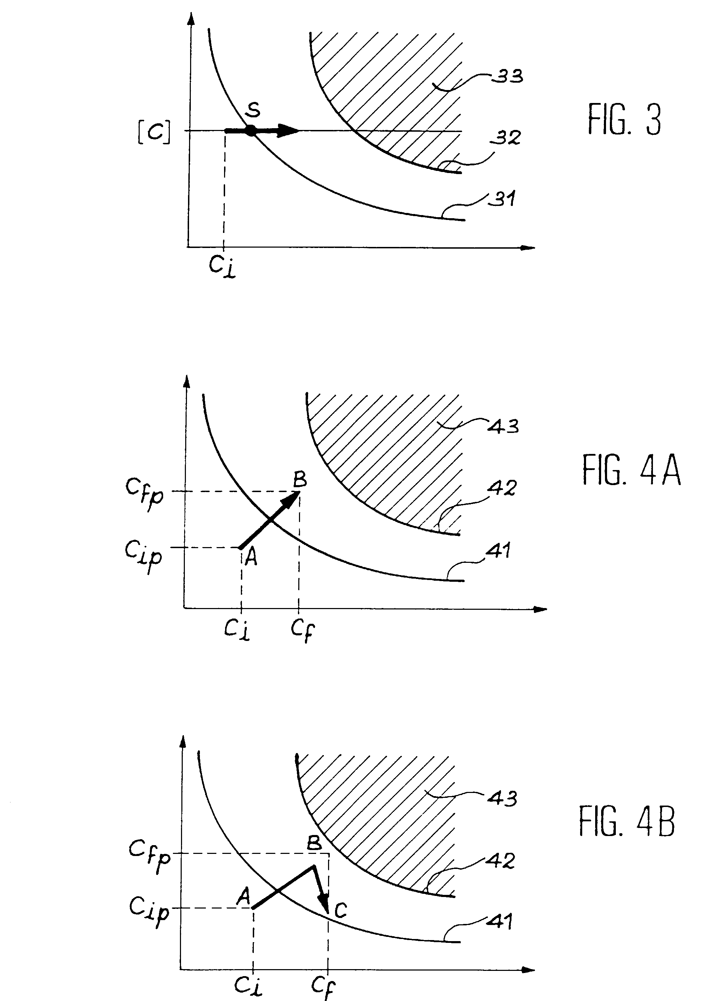

Les figures 3, 4A et 4B extraites du document de Ducruix et Giégé déjà mentionné ci-dessus, donnent l'allure du diagramme de phases dans le plan : concentration en protéine en fonction de la concentration en sel précipitant.

On a représenté les courbes de solubilité (31, 41) et les courbes de précipitation (32, 42) ainsi que la zone de précipitation (33, 43) . Les concentrations initiales et finales en agent précipitant et en protéine sont représentées respectivement par Ci, Cf et Cip, Cfp.

La chronologie est la suivante :

La concentration du composé précipitant (dans ce cas un sel) augmentant, la solution de protéine devient sursaturée ; puis le taux de sursaturation continuant à croître, la solution atteint le domaine de nucléation spontanée situé au-delà de la courbe de solubilité (31,41), c'est-à-dire que le point figuratif passe de A à B sur la figure 4A. Le ou les germes qui apparaissent grossissent et, de ce fait, épuisent la solution. Le point figuratif passe donc de B à C (figure 4B). Les cristaux cessent de croître quand la limite de saturation est atteinte au point C.

Dans le cas de la cristallogénèse des protéines par les procédés courants cités ci-dessus tels que ceux du type goutte posée dénommé "sitting drop method" ou goutte suspendue, encore dénommé "hanging drop method", on ne peut éviter la nucléation hétérogène au contact des parois du récipient ainsi que les problèmes de contamination liés au support.

La gamme des moyens de contrôle de la concentration des réactifs dans la goutte est très limitée et il en est donc de même du contrôle de la nucléation et de la vitesse de croissance liées à cette concentration. C'est la raison pour laquelle ont été développés les procédés d'élaboration dits "sans contact" qui présentent, par rapport aux procédés courants tels que ceux du type goutte posée ou suspendue, l'avantage de supprimer ces problèmes de nucléation hétérogène et de contaminations liées au support, ainsi que d'offrir la possibilité de suivre aisément la composition dans la goutte.

Il existe de nombreux procédés d'élaboration sans contact de cristaux tels que des cristaux de protéine ; il s'agit par exemple du procédé dit de cristallisation par "pression de radiation optique" mettant en oeuvre un laser qui est décrit dans le document de A. ASHKIN : "Application of Laser Radiation Pressure" ; Science, 5 December 1980, Vol. 210, N°4474, p 1081-1088 où est évoquée l'application éventuelle de la pression de radiation à l'étude de processus fondamentaux tels que la sursaturation de gouttes ou leur cristallisation.

Un autre procédé est le procédé dit de cristallisation par lévitation électrostatique qui est décrit dans le document de RHIM W.K., CHUNG S.K., HYSON M. T., ELLEMAN D. D. "Charged drop levitators and their applications" ; Material Processing in the reduced gravity environment of space. Symposium tenu du 1 au 3 Décembre 1986, Boston, Mass., U.S.A. Material Research Society Symposia Proceedings. Volume 87. 1987, p. 103-112.

Ce procédé réalisable en l'absence de pesanteur, dans l'espace, ou au sol consiste à mettre en lévitation entre deux électrodes une goutte d'eau chargée d'un diamètre de 3 mm, et à y faire croître par exemple un cristal de NaCl.

Le document de RHIM W.K., CHUNG S.K. "Containerless protein crystal growth method". Crystal growth of Biological Macromolecules. Third International. Conf. Washington, U.S.A. Août 1989, Journal of Crystal Growth. Vol. 110, (1991) n° 1-2, p. 293-301, est également relatif à un procédé de lévitation électrostatique, dans lequel on fait croître des cristaux de protéines, par exemple de lysozyme de blanc d'oeuf de poule à partir de gouttes placées en lévitation électrostatique dans des laboratoires spatiaux en microgravité ou dans des laboratoires au sol à gravité normale de 1 g. Il est indiqué que la taille de la goutte d'eau que l'on peut placer en lévitation ne peut excéder environ 86 µl et en pratique ne dépasse pas 30 µl.

Un autre procédé est le procédé de lévitation acoustique qui est notamment décrit dans le document de TRINH E.H. "Compact acoustic levitation device for studies in fluid dynamics and material science in the laboratory and microgravity". Review of Scientific Instruments. Vol. 56(11), November 1985, p. 2059-2065, et le document de TRINH E.H., ROBEY J., ARCE A., GASPAR M. "Experimental studies in fluid mechanics and material science using acoustic levitation". Material Processing in the reduced gravity environment of space. Symposium tenu du 1 au 3 Décembre 1986, Boston, Mass., U.S.A., Material Research Society Symposia Proceedings. Volume 87. 1987, p. 57-69.

Ce procédé, applicable dans des conditions de gravité normale et de microgravité, a permis la lévitation de gouttes de 2 mm de diamètre, et la cristallisation, notamment de O-terphényle. Les deux derniers procédés décrits ci-dessus ont été associés dans un procédé hybride acoustique et électrostatique dans le document de RHIM W.K., CHUNG S.K., TRINH E. H., ELLEMAND D.D. : "Charged drop dynamics experiment using an electrostatic-acoustic hybrid system" ; Material Processing in the reduced gravity environment of space ; Symposium tenu du 1 au 3 Décembre 1986, Boston, Mass., U.S.A., Material Research Society Symposia Proceedings. Volume 87. 1987, pp 329-337 ou des gouttes chargées des gouttes de 3 mm de diamètre ont été placées électrostatiquement en lévitation puis mises acoustiquement en rotation et en oscillation.

Les documents de COUTURES J.P., RIFFLET J.C., BILLARD D., COUTURES P. "Contactless treatment of liquids in a large temperature range by an aerodynamic levitation device and laser heating" ; Proc. of the 6th European Symposium on Material Sciences under microgravity conditions, Bordeaux, 2-5 Décembre 1986, ESA SP-256, 1987, p. 427-430, et de WEBER J.K.R., SCHIFFMAN R.A., KRISHNAN S., NORDINE P.C. "Containerless processing and property measurements of high temperature liquids and solids" ; Proc. of the 7th European Symposium on Material Sciences under microgravity conditions, Oxford, RU 10-15 Septembre 1989, ESA SP-295, 1990, p. 639-643 ont trait à un procédé associant un dispositif aérodynamique et un chauffage avec un laser à CO₂ pour étudier à haute température la solidification de liquides, sans contact, afin d'obtenir des matériaux amorphes, vitreux.

Enfin les documents de
- WEBER J.K.R.,NORDINE P.C. :"Containerless Liquid phase Processing of Ceramic Materials", Microgravity Science and Technology, Vol. VII/4, Février 1995, p. 279-282, et de
- WEBER J.K.R., et de HAMPTON D.S., MERKLEY D.R. REY C.A., ZATARSKY M. M., NORDINE P.C. : "Aero-acoustic levitation : A method for containerless liquid-phase processing at high temperature" ; Review of Scientific Instruments. Vol. 65 (2), Février 1994, p. 456-465, décrivent-ils dans un environnement de microgravité, l'association de procédés de lévitation aéro-acoustique et aérodynamiques avec un chauffage et une fusion par laser pour étudier le traitement, et en particulier la solidification, de céramiques et de verres.

Tous les procédés d'élaboration sans contact décrits ci-dessus, s'ils permettent de surmonter certains des inconvénients des procédés classiques avec contact, ne permettent de traiter que de très faibles volumes de solution, à titre d'exemple, les ordres de grandeur des capacités maximum actuelles des procédés d'élaboration sans contact vont de 10⁻⁶ ml pour le procédé à pression de radiation jusqu'à 10⁻¹ ml pour les autres procédés, ce qui est notoirement insuffisant notamment pour faire croître des cristaux de dimension suffisante aux fins d'analyse radiocristallographiques.

Par ailleurs, le document FR-A-2 509 637 décrit le procédé de sustentation sur film de gaz qui permet la sustentation, le positionnement et le moulage d'une masse liquide, sans contact avec une paroi. La masse liquide est séparée de la paroi par une couche sous pression d'un gaz chimiquement inerte vis-à-vis de la masse liquide et du matériau constitutif de la paroi. Ce procédé permettrait de sustenter un volume de solution très supérieur à ceux des procédés mentionnés ci-dessus et pourrait être utilisé pour des volumes jusqu'à 10 ml et pouvant atteindre 100 ml.

Ce document décrit également l'application de ce procédé à la sustentation de gouttes liquides sur une paroi poreuse plane et horizontale, à la mise en forme d'une masse liquide à l'intérieur d'un récipient cylindrique dont le fond et les parois sont poreux, afin de permettre le passage d'un gaz, à la fusion de zone sur des pièces de dimensions importantes, à la mise en forme d'une pièce cylindrique liquide en micro-gravité, à la coulée continue, et à la réalisation de monocristaux par traction verticale.

Toutes ces opérations sont donc des opérations réalisées en milieu homogène, et à l'origine, monophasique, concernant en particulier des changements d'état d'un seul et même composé. Il s'agit par exemple de la fusion, de la solidification d'un lingot homogène. Il ne se produit pas au sein de la masse une quelconque réaction chimique, ou une cristallisation ou autre, impliquant la présence de plusieurs réactifs ou d'un couple solvant-soluté(s). Il semble a priori impossible d'envisager qu'un tel procédé, mis en oeuvre jusqu'à présent exclusivement dans le domaine limité de la métallurgie et confiné à des applications spécifiques en milieu homogène, puisse être appliqué à la réalisation d'une réaction dans un milieu liquide hétérogène comprenant une pluralité de réactifs, par exemple à une cristallisation impliquant un ou des solvant(s) et un ou plusieurs soluté(s). Le document FR-A-2 509 637 mentionné et commenté ci-dessus qui est un document relativement ancien (1981) ne contient aucune indication ni aucune suggestion allant dans ce sens.

L'invention a pour objet, entre autres, de surmonter les problèmes rencontrés par les procédés de l'art antérieur et de remédier aux inconvénients de ces procédés.

Cet objet, et d'autres encore, sont atteints conformément à l'invention par un procédé d'élaboration d'au moins un cristal, caractérisé en ce que ledit cristal est élaboré dans un milieu mis en sustentation sur un film de gaz. Par élaboration d'au moins un cristal, on entend un processus comprenant essentiellement des étapes de nucléation d'un germe à partir du milieu puis de croissance de ce germe jusqu'à l'obtention d'un cristal présentant la taille souhaitée.

Selon une variante du procédé selon l'invention, au lieu de partir du milieu de départ tel qu'une solution limpide où l'on provoque la nucléation d'un germe, puis sa croissance, on peut introduire un germe exogène dans le milieu, tel qu'une solution, c'est ce que l'on nomme l'étape d'ensemencement, puis le faire croître comme dans la première variante afin d'obtenir un cristal de la taille souhaitée.

Selon l'invention, le processus d'élaboration, c'est-à-dire la nucléation et la vitesse de croissance, notamment, est de préférence maîtrisé, régulé, contrôlé par l'intermédiaire d'un ou de plusieurs paramètres influençant en particulier l'évaporation du milieu et donc la concentration des réactifs dans ce milieu, parmi lesquels on peut citer à titre non limitatif le débit de gaz de sustentation, l'hygrométrie relative et la température du gaz de sustentation, la température du diffuseur de gaz, la température du milieu mis en sustentation tel qu'une goutte et l'hygrométrie relative à sa surface, la température et l'hygrométrie relative dans l'enceinte loin de la goutte, la température de la paroi de l'enceinte, etc.

Le procédé selon l'invention présente les avantages présentés généralement par les procédés sans contact, en effet l'absence de contact avec une quelconque paroi permet une limitation de la nucléation hétérogène. De ce fait, les cristaux élaborés présentent peu de défaut de croissance et leur forme, généralement isomérique, est parfaitement maîtrisée.

D'autre part, il est possible de parfaitement contrôler l'évaporation du milieu de préférence sous forme d'une goutte par le jeu d'un ou de plusieurs des différents paramètres mentionnés ci-dessus, ce qui, en conséquence, permet de moduler la vitesse de variation de la concentration des réactifs et donc la vitesse de croissance du cristal. Le contrôle dynamique des paramètres constitue l'un des aspects particulièrement avantageux du procédé de l'invention dans le cas où il est mis en oeuvre dans des conditions de gravité réduite ou de microgravité.

D'autre part encore, et contrairement aux autres procédés connus d'élaboration de cristaux, sans contact, les volumes de milieu, par exemple de solution, traités, peuvent être importants : à titre d'exemple, ils seront compris entre 5 µl et 100 ml, de préférence entre 5 et 25 ml, ce qui est nettement supérieur aux volumes mentionnés ci-dessus pour les procédés sans contact de l'art antérieur.

Enfin, du fait que le dispositif pour la mise en oeuvre du procédé selon l'invention, a une enceinte d'un volume nettement supérieur aux dispositifs de l'art antérieur, la place disponible permet d'installer dans cette enceinte divers dispositifs additionnels, par exemple, il sera possible d'envisager l'installation de moyens de diagnostic in situ.

L'invention apparaîtra plus clairement à la lecture de la description qui va suivre, donnée à titre d'exemple illustratif et nullement limitatif, en référence aux dessins joints dans lesquels :
- les figures 1A, 1B et 1C sont des représentations schématiques des procédés de l'art antérieur les plus courants, à savoir goutte suspendue : fig. 1A, goutte posée : fig. 1E, et goutte sandwich : fig. 1C.
- la figure 2 est une représentation schématique de la cristallisation par le procédé en goutte suspendue "hanging drop method",
- les figures 3, 4A et 4B donnent une représentation schématique du diagramme de cristallisation dans les procédés mettant en oeuvre la diffusion de vapeur. La concentration en protéine est représentée en ordonnée et la concentration en agent de cristallisation ou de précipitation est représentée en abscisse,
- la figure 5 représente schématiquement un dispositif pour la mise en oeuvre du procédé selon l'invention et sert de référence pour définir les différents paramètres qui influencent la cristallisation et les notations utilisées,
- la figure 6 illustre la structure d'une enceinte de traitement qui peut être utilisée pour la mise en oeuvre du procédé selon l'invention,
- la figure 7 est le tableau synoptique général d'une installation de cristallogénèse de protéines par sustentation sur film de gaz,
- la figure 8 est un diagramme montrant la variation relative du volume de la goutte de solution saline V/V₀ exprimé en %, en fonction du temps exprimé en heures. V₀ désigne le volume initial de la goutte.

Les courbes en trait continu, en trait pointillé, et en trait interrompu représentent les résultats obtenus respectivement avec des concentrations initiales (Ci) en NaCl de 0,3 ; 0,5 et 0,7 mole/litre et RH∞ environ de 100 %.
- la figure 9 est un diagramme montrant la variation relative du volume de la goutte d'eau pure V/V₀ exprimé en %, en fonction du temps exprimé en minutes.

Les courbes en trait continu, et en trait pointillé représentent les résultats obtenus respectivement avec des valeurs de RH∞ (voir plus loin) de 0 % et de 40 %.

Selon l'invention, le milieu mis en sustentation a de préférence la forme d'une goutte, cette forme étant dictée par les caractéristiques inhérentes au procédé

Ce milieu peut être tout milieu pouvant être mis en sustentation de manière adéquate, mais il s'agit de préférence d'une masse fluide, liquide ou gélifiée. Le milieu est encore de préférence une solution, de préférence une solution aqueuse, mais il est bien évident que d'autres solvants ou mélanges de solvants peuvent être envisagés tels que alcools, polymères, fluorocarbones, sels, laitiers,...

La solution peut comprendre un seul des composés indiqués ci-dessus comme solvant, mais peut aussi comprendre un mélange de deux ou plus de ces solvants. L'eau et le solvant préféré, en particulier lorsqu'on désire élaborer des cristaux organiques et/ou biologiques tels que des cristaux de macromolécules organiques et/ou biologiques, par exemple de protéine(s).

Le solvant contient également un composé dont on cherche à élaborer un ou des cristaux. Ce composé peut être tout composé susceptible de donner naissance à un ou à des cristaux. Il peut s'agir d'un composé organique, ou inorganique par exemple minéral tel que le sulfate d'ammonium, le chlorure de sodium, ou bien un polymère, un alcool tel que le polyéthylène glycol ou le méthyl-pentanediol. Selon une forme de réalisation particulièrement préférée du procédé selon l'invention, les composés sont des macromolécules organiques telles que les acides nucléiques et en particulier des protéines telles que les enzymes, les hormones, les récepteurs, etc. Le composé à cristalliser est généralement présent à une concentration initiale dans le milieu comprise entre 1 et 30 mg/ml.

On peut faire croître dans chacun des milieux, par exemple gouttes, mis en sustentation, un ou plusieurs cristaux selon l'application que l'on fait du procédé selon l'invention.

Par exemple, si l'on souhaite obtenir un cristal de taille, de forme et de qualité suffisantes pour pouvoir effectuer l'étude de sa structure, il sera préférable de ne faire croître qu'un cristal par milieu ou goutte ; on pourra alors mettre plusieurs milieux simultanément en sustentation pour élaborer simultanément plusieurs cristaux.

Si le procédé selon l'invention est utilisé comme technique séparative, par exemple par cristallisation fractionnée, il sera alors préférable de faire croître plusieurs cristaux par milieu ou goutte.

Comme on l'a déjà mentionné, l'application du procédé en vue en particulier de l'obtention d'un cristal de dimension satisfaisante peut s'opérer de deux manières. Soit, dans une première variante, on part d'une solution limpide contenant le composé à cristalliser et l'on provoque la nucléation d'un germe, puis sa croissance. Soit on introduit un germe exogène d'une taille par exemple de quelques microns à quelques dizaines de microns dans la solution, c'est ce que l'on appelle l'ensemencement, puis on le fait croître.

Le milieu mis en sustentation peut également comprendre un composé par exemple un sel précipitant tel que le NaCl ou le (NH₄)₂SO₄ à une concentration initiale comprise entre 5 et 50 % (poids ou volume).

Un tampon de réglage du pH peut également être présent dans le milieu : ce tampon peut être choisi parmi les systèmes tampons connus de l'homme du métier. Il peut s'agir par exemple d'un tampon TRIS permettant de tamponner le milieu (aqueux) à un pH de 8,5 à 7 ou encore d'un tampon cacodylate permettant de tamponner le milieu à un pH de 6 à 5.

On a vu ci-dessus que le volume initial du milieu, c'est-à-dire par exemple de la goutte est, de préférence, conformément à l'une des caractéristiques avantageuses de l'invention compris entre 30 et 100 µl, et mieux encore entre 50 et 60 µl, ce qui est un volume sensiblement plus important que les volumes initiaux des milieux des procédés de l'art antérieur sans contact.

Le gaz utilisé pour la mise en sustentation doit de préférence être chimiquement neutre vis-à-vis du milieu mis en sustentation ; on utilisera de préférence un gaz tel que l'hélium, l'argon, l'azote ou bien encore l'air filtré.

Le débit de gaz de sustentation doit être suffisant pour maintenir le milieu en sustentation ; il doit également être constant et peut être déterminé aisément par l'homme du métier dans ce domaine de la technique ; il sera compris de préférence entre 1 et 100 ml/mn.

Le procédé selon l'invention peut être mis en oeuvre dans des conditions de gravité normale, par exemple au sol, ou bien dans des conditions de gravité réduite ou de microgravité, par exemple dans un vaisseau spatial où le contrôle dynamique de paramètres devient l'aspect le plus innovateur de l'invention.

Le procédé selon l'invention selon l'une de ses caractéristiques particulièrement avantageuse permet de maîtriser, de réguler, de contrôler le processus d'élaboration par l'intermédiaire d'un certain nombre de paramètres.

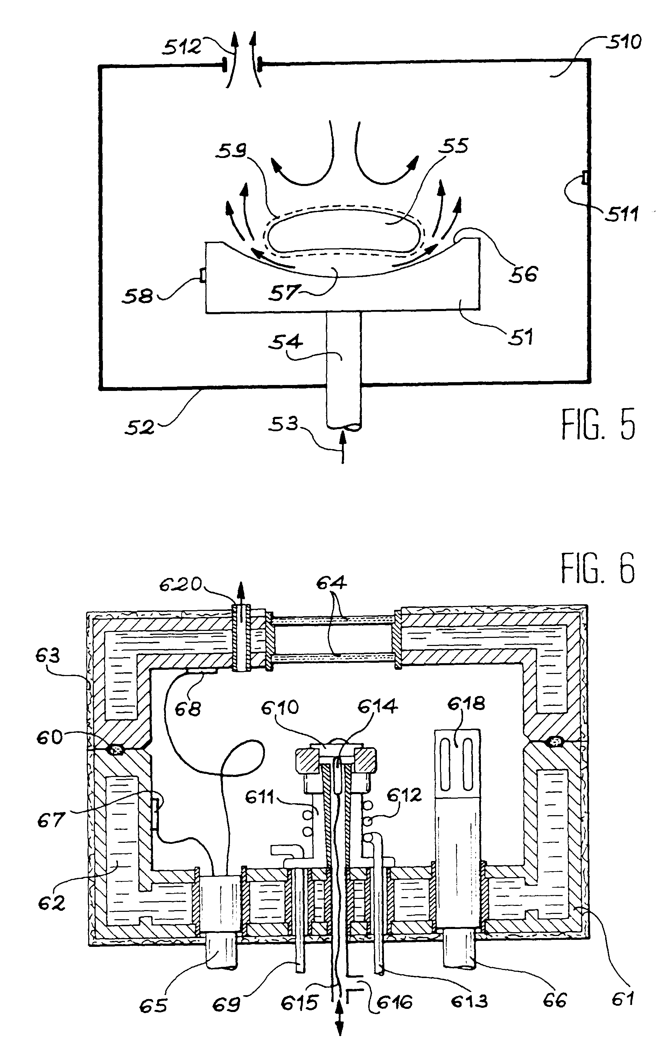

La figure 5 illustre de manière schématique un dispositif susceptible d'être utilisé pour la mise en oeuvre du procédé selon l'invention, et effectue l'inventaire des paramètres influents et des notations utilisées dans le cas général de la sustentation sur film de gaz d'une masse fluide ou gélifiée.

Ce dispositif comprend essentiellement des moyens permettant de mettre le milieu en sustentation sous la forme par exemple d'un diffuseur (représenté généralement par la référence (51) placé dans une enceinte (52). Le gaz de sustentation (53) alimente le diffuseur (51) par l'intermédiaire de moyens d'alimentation sous la forme par exemple, d'une canalisation d'alimentation (54) traversant l'enceinte (52). Le gaz en excès est évacué par l'intermédiaire de moyens d'évacuation sous la forme par exemple d'un orifice d'échappement (512).

Le diffuseur peut être notamment du type de celui décrit dans le document FR-A-2 509 637 déjà mentionné ci-dessus, c'est-à-dire que la masse du milieu à supporter, qui peut être par exemple une goutte (55) d'une masse fluide ou gélifiée, est supportée au-dessus d'une paroi (56) à l'aide d'un film de gaz (57). La plaque (56) est poreuse et constitue la paroi diffusante d'une chambre permettant la mise en pression et en température du gaz employé.

On place directement le milieu à sustenter, par exemple une goutte de liquide, en contact avec la paroi, et on la soulève en forçant une masse de gaz tel que de l'hélium à travers cette paroi qui peut par exemple être constitué de graphite ou céramique ou matériau synthétique et avoir une épaisseur par exemple de 1 à 5 mm.

Afin de maintenir la goutte (55) au même endroit de la surface externe de la plaque (56), on a donné à celle-ci sur la figure 5 une forme légèrement concave. En effet, le poids de la goutte étant équilibré par la pression du film de gaz, si aucune force de rappel ne la maintient, elle acquiert une grande mobilité sous l'effet de forces minimes non contrôlées. C'est pourquoi l'on prévoit de préférence une telle forme de paroi légèrement concave afin d'éviter un déplacement accidentel de la goutte.

On a vu dans ce qui précède que dans le cas du procédé courant dit de la goutte suspendue de nombreux auteurs ont étudié le mécanisme des transferts de masse, à savoir essentiellement de la vapeur d'eau entre la goutte et le réservoir. La diffusion moléculaire de la vapeur d'eau dans l'air explique assez bien la cinétique de variation de la concentration en sel précipitant en fonction du temps. Le temps nécessaire à l'obtention de l'équilibre est de l'ordre de la centaine d'heures.

Dans le cas de la sustentation sur film de gaz, du fait du débit de gaz, de préférence d'air nécessaire à la sustentation, on a un système ouvert. La convection forcée autour du milieu mis en sustentation par exemple de la goutte "balaye" la couche limite, et on a une évacuation permanente par exemple d'eau qui doit être compensée par ailleurs.

La figure 5 donne l'inventaire des paramètres influents et les notations utilisées :
- Q_{g} désigne le débit de gaz de sustentation arrivant par la canalisation (54),
- Rh_{g}, T_{g} désignent l'hygrométrie relative et la température (°C) du gaz de sustentation (53).
- T_{d} désigne la température du diffuseur prise en (58) à l'aide de moyens de mesure de la température Td, par exemple à l'aide d'une sonde de température sous forme de sonde à résistance de platine ou thermistance.
- Tₐ et Rhₐ désignent la température de la goutte, supposée isotherme, et l'hygrométrie relative à sa surface en (59),
- T_{∞} et RH_{∞} désignent la température et l'hygrométrie relative dans l'enceinte, loin de la goutte, par exemple en (510) et peuvent être mesurées par des moyens de mesure, par exemple par des capteurs et sondes, adéquats,
- Tₚ désigne la température de la paroi de l'enceinte prise par exemple en (511) à l'aide de moyens de mesure, par exemple à l'aide d'un ou de plusieurs sonde(s) ou capteur(s), adéquat(s), tels que sonde(s) à résistance de platine (Pt) ou thermistance.

En première approximation Tp est égal à Tg qui est voisin de Td, à savoir de 0 à 40°C.

Les flux surfaciques par exemple de vapeur d'eau sont proportionnels au gradient de concentration dans la couche limite de la phase gazeuse à la surface de la goutte.

Compte tenu des contraintes géométriques liées au procédé de sustentation, le volume de l'enceinte est supérieur à celui du procédé, pris comme procédé de référence à savoir le procédé dit "goutte suspendue", par exemple le volume de l'enceinte est de deux ordres de grandeur supérieurs à celui du procédé de référence. Un circuit de gaz humide additionnel tel que de l'air permet d'une part de diminuer la constante de temps d'établissement du degré hygrométrique souhaité dans l'enceinte après ouverture, et d'autre part de le maintenir pendant toute la durée de l'expérience.

Le procédé selon l'invention permet de maîtriser et de contrôler la nucléation, puis la vitesse de croissance des faces du ou des cristaux par l'intermédiaire de l'un ou de plusieurs des paramètres énumérés ci-dessus : par exemple, on pourra réaliser une évaporation de la goutte à T_{∞} constante et RH_{∞} variable ou une évaporation de la goutte à T_{∞} variable, ou bien une évaporation de la goutte par variation de Rh_{g} et/ou T_{g}, ou on peut faire varier les concentrations par injection de solvant ou de réactifs dans la goutte, ou enfin on peut faire varier la concentration en sel précipitant dans le réservoir à l'image de ce qui se fait dans le procédé de référence à goutte suspendue.

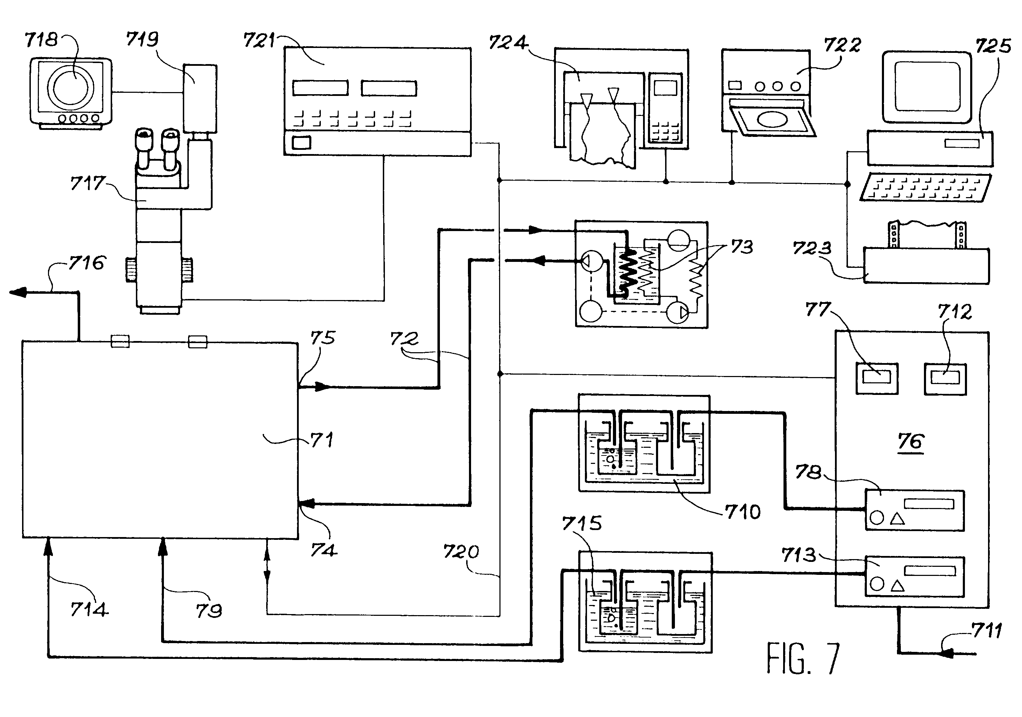

La figure 6 illustre la structure de l'enceinte du lévitateur permettant la mise en oeuvre du procédé selon l'invention, notamment pour la sustentation de solutions aqueuses.

Cette enceinte est une enceinte à double paroi (61) réalisée dans un matériau adéquat compatible avec les réactifs mis en oeuvre à l'intérieur de l'enceinte ; ainsi l'enceinte peut-elle être réalisée en aluminium ou bien en verre.

Selon la figure 6, l'enceinte est réalisée sous la forme de deux demi-enceintes, l'une d'entre elles formant couvercle, entre lesquelles est placé par exemple un joint d'étanchéité. Cette enceinte est pourvue de moyens permettant de réguler la température intérieure qui se présentent en particulier sous la forme suivante : Dans la double paroi circule un liquide thermostaté (62) par exemple de l'eau ou un mélange d'eau et d'éthylène glycol en provenance de la boucle de thermostatage décrite dans la figure 7. Cette enceinte est de préférence doublée par un matériau calorifuge (63) tel que du liège ou une mousse synthétique, ce qui permet de maintenir à l'intérieur de l'enceinte une température de préférence comprise entre 0 et 40°C, de préférence supérieure à 0°C, et sensiblement constante, c'est-à-dire de préférence avec une variation ne dépassant pas ± 0,05°C.

L'expérience en cours à l'intérieur de l'enceinte peut être suivie par l'intermédiaire de un ou plusieurs moyens d'observation tels que des hublots (64) prévus dans la double paroi.

L'enceinte est munie de plusieurs connecteurs (65, 66) ou d'autres moyens permettant de faire traverser cette enceinte aux différents câblages et alimentations reliés aux divers moyens et dispositifs de mesure, sondes, capteurs disposés à l'intérieur de l'enceinte. Ainsi, sur la figure 6, le dispositif comprend-il un premier connecteur (65) pour le passage des fils reliés aux moyens de mesure de la température tels que des sondes à résistance de platine "Pt 100" de mesure de la température. Sur la figure 6, deux de ces sondes (67, 68) ont été représentées ; il est bien évident que le nombre et le type de ces sondes peut varier et peut être aisément déterminé par l'homme du métier. Sur la figure 6, le dispositif représenté comprend un second connecteur (67) pour le passage et le support, et la connexion de moyens de mesure de l'hygrométrie à l'intérieur de l'enceinte tels qu'une sonde d'hygrométrie (618) constituée par exemple par une capacitance variable qui permet de mesurer l'hygrométrie RH_{∞} ou un miroir à température contrôlée, permettant la mesure du point de rosée. L'enceinte comprend aussi des moyens tels qu'un piquage pour l'alimentation en gaz de balayage (69). Ce gaz peut être par exemple de l'air ou de l'azote et il est bien entendu choisi pour être compatible avec les réactifs mis en oeuvre ainsi qu'avec les matériaux formant le diffuseur, l'enceinte, et les moyens de mesure. Ce gaz est généralement le même que le gaz de sustentation.

L'enceinte comprend également des moyens tels qu'un perçage (620) pour réaliser l'évacuation des gaz de l'enceinte.

La partie essentielle du dispositif selon l'invention est constituée par les moyens permettant de mettre le milieu en sustentation qui prennent sur la Fig. 6 la forme d'un diffuseur (610) dont la partie utile est, par exemple, un secteur sphérique qui est monté sur une chambre de pressurisation (611) comportant des moyens de régulation de la température qui consistent de préférence, comme montré sur la figure 6 en un serpentin (612) alimenté par un fluide de thermostatage tel qu'un mélange eau/éthylène glycol par le tube (613).

Ces moyens de régulation de la température, permettent, si besoin est, de thermostater le diffuseur à une température Td comprise par exemple entre 0 et 40°C, de préférence supérieure à 0°C, différente de celle des parois de l'enceinte. Le diffuseur comporte également des moyens de mesure de la température constitué par exemple par une sonde de température, par exemple de type à résistance de platine "Pt 100" (614) dont le câble de connexion (615) passe par le piquage d'alimentation en gaz de sustentation (616).

La disposition du diffuseur de l'appareil décrit à la figure 6 n'est donnée qu'à titre d'exemple. Il est possible de concevoir le sous-ensemble formant le diffuseur de manière différente, en particulier dans le cas d'un appareil destiné à être mis en oeuvre à une échelle industrielle, de façon à permettre alors la sustentation simultanée de plusieurs milieux ou gouttes, par exemple de 2 à 10 ou plus, à l'image de ce qui se fait couramment dans le procédé de référence à goutte suspendue, ce qui permettra de mener plusieurs essais en parallèles et d'élaborer par exemple simultanément plusieurs cristaux.

Comme on l'a déjà indiqué dans ce qui précède, l'enceinte de traitement conformément à l'invention est équipée de moyens de mesure tels que de capteurs et de sondes par exemple de la température, de l'hygrométrie et/ou du point de rosée, qui mesurent en particulier l'hygrométrie et la température de l'atmosphère de l'enceinte loin de la goutte : RH_{∞} et T_{∞} ainsi que la température du diffuseur qui peut être considérée comme étant égale à la température Tg du gaz de sustentation.

La figure 7 représente l'installation complète de sustentation notamment de solutions aqueuses sur film de gaz permettant notamment de réaliser la cristallogénèse de protéines.

Dans cette installation, l'enceinte décrite ci-dessus sur la figure 6 est représentée schématiquement en (71). La double paroi de cette enceinte est reliée à la boucle de thermostatage (72) comprenant un appareil de contrôle de la température (73) tel qu'un thermostat par les tubes d'arrivée (74) et de sortie (75) acheminant un liquide thermostaté tel que de l'eau ou l'éthylène glycol qui permet de réguler la température à l'intérieur de l'enceinte (71) à une température comprise de préférence entre 0 et 40°C, de préférence encore supérieure à 0°C, avec de préférence une variation ne dépassant pas plus ou moins 0,05°C.

Le gaz de sustentation par exemple de l'air ou de l'azote, alimentant le diffuseur à un débit de préférence de 1 à 100 ml/mn provient de la baie de contrôle et de régulation (76) de l'alimentation en gaz munie d'un débitmètre (77) et d'une vanne de réglage (78) du débit passe tout d'abord avant d'être envoyé dans la canalisation (79) aboutissant dans l'enceinte, et plus précisément dans le diffuseur, dans un appareil barboteur, constitué par exemple d'un bain thermostaté (710), qui permet de régler son hygrométrie relative à une valeur comprise entre 90 et 100 % RH et sa température à une valeur de préférence comprise entre 0 et 40°C, de préférence encore supérieure à 0°C.

Un deuxième circuit d'alimentation en gaz permet le balayage de la chambre avec un débit de préférence de 0,1 à 5 l/mn, beaucoup plus important que celui du circuit de sustentation : ce débit est encore de préférence compris entre 0,2 et 2 l/min. De manière analogue au gaz de sustentation, le gaz de balayage qui est de préférence le même que le gaz de sustentation provient de l'arrivée commune de gaz par l'intermédiaire de la baie de contrôle et de régulation de l'alimentation en gaz qui est munie de moyens de contrôle, de régulation et de mesure du débit sous la forme par exemple d'un débitmètre (712) et d'une vanne de réglage (713) du débit et passe tout d'abord, avant d'être envoyé dans l'enceinte par l'orifice d'entrée (714), dans un appareil barboteur constitué d'un bain thermostaté (715) qui permet de régler son humidité relative à une valeur comprise entre 90 et 100 % RH et sa température à une valeur de préférence comprise entre 0 et 40°C, de préférence encore supérieure à 0°C. Les gaz de sustentation et de balayage en excès peuvent être évacués de l'enceinte par l'orifice d'échappement (716) et recyclés.

Le circuit d'alimentation en gaz de balayage permet, après une opération d'ouverture et de fermeture de l'enceinte de rétablir l'hygrométrie relative de l'atmosphère de l'enceinte avec une constante de temps beaucoup plus faible.

L'installation comprend également des moyens d'observation du liquide placé en sustentation. Les moyens comprennent par exemple un microscope stéréoscopique (717), grâce auquel on peut observer la goutte, soit directement à l'oculaire, soit sur un moniteur de télévision (718) via une caméra (719). Le signal vidéo est éventuellement enregistré sur des moyens d'enregistrement tels qu'un magnétoscope.

Les mesures recueillies dans l'enceinte par les divers moyens de mesure de température et d'hygrométrie sont transmises par la ligne 720 à des moyens d'acquisition et de traitement comprenant par exemple une centrale de mesure (721) et un micro-ordinateur (725) par exemple du type HP 3852 commercialisé par la Société HEWLETT-PACKARD couplé à des moyens d'impression tels qu'une imprimante (723) qui permet donc l'acquisition des mesures, la commande périodique de l'éclairage et la sortie d'un cliché papier sur l'imprimante vidéo (722) grâce auquel on peut a posteriori mesurer le diamètre de la goutte et le calcul de son volume ouvert. Les signaux analogiques sont enregistrés sur papier (724) en tracé continu.

Les moyens de contrôle de régulation et de mesure de l'hygrométrie de l'enceinte et du gaz de sustentation décrits dans ce qui précède ne sont donnés qu'à titre indicatif. Il est bien évident que d'autres moyens de contrôle de régulation et de mesure peuvent être mis en oeuvre, en particulier dans le cadre d'une réalisation à l'échelle industrielle de l'installation.

Il en est de même pour les moyens de contrôle, de régulation et de mesure de la température ; pour les moyens de contrôle, de régulation et de mesure des différents débits ; pour les moyens de mise en sustentation ; pour les moyens d'alimentation et d'évacuation des différents gaz et autres fluides ; pour l'enceinte elle-même ; pour les moyens d'observation dont elle est pourvue ; pour les moyens d'acquisition de traitement, de reproduction et d'impression et pour tous les autres moyens prévus dans le dispositif et l'installation de l'invention.

L'invention sera mieux comprise à la lecture de la description suivante d'exemples de réalisation de l'invention donnés à titre d'exemple illustratif et non limitatif.

### EXEMPLE 1 :

L'hygrométrie relative de l'enceinte telle que décrite ci-dessus est maintenue égale à 100 %, c'est-à-dire que RH_{∞} = 100 %. Selon la nomenclature utilisée ci-dessus, on a mesuré la variation relative V/Vₒ exprimée en pour cents, en fonction du temps exprimé en heures, du volume d'une goutte de solution de chlorure de sodium (V) dont le volume initial est de 70 µl.

Les valeurs des concentrations initiales choisies (Co), à savoir 0,3 ; 0,5 et 0,7 mole/l, correspondent à celles utilisées, par exemple, dans le cas de la croissance de lysozyme de blanc d'oeuf de poule.

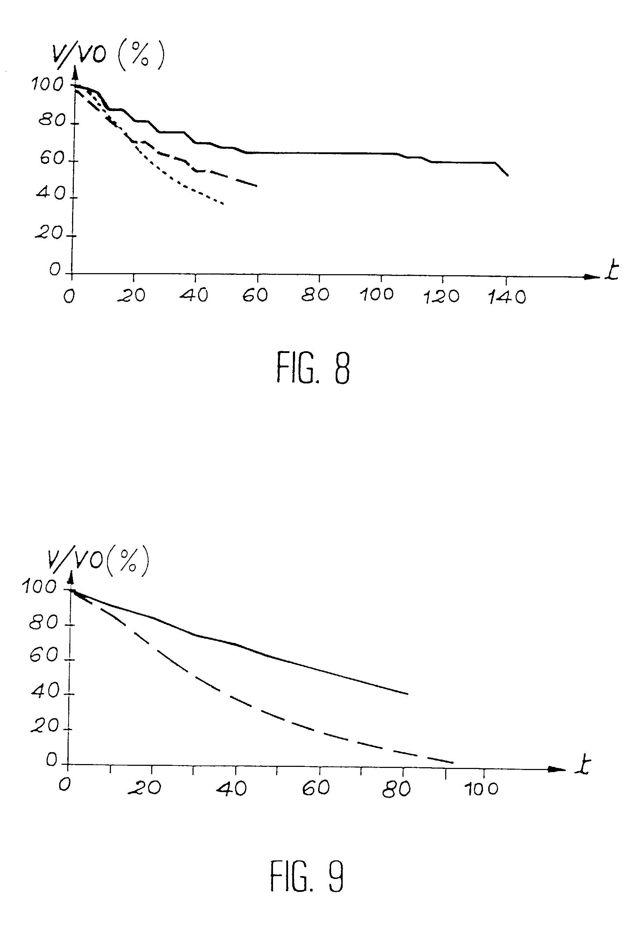

Les cinétiques d'évaporation obtenues sont représentées sur la figure 8 respectivement en trait continu (0,7 mol/l), en trait pointille (0,5 mol/l) et en trait mixte (0,3 mol/l).

On note que les cinétiques d'évaporation obtenues sont du même ordre que celles constatées dans le cas du procédé de référence, c'est-à-dire 24 à 48 heures pour atteindre le volume moitié. Dans le cas de l'essai avec une concentration initiale de 0,7 mol/l, on a, de plus, obtenu la stabilisation du volume de la goutte, comme c'est le cas dans le procédé de référence.

### EXEMPLE 2

On a mesuré la variation relative V/Vₒ exprimée en pour cents, en fonction du temps exprimé en minutes, du volume d'une goutte d'eau pure en faisant varier l'hygrométrie relative dans l'enceinte. Le volume initial de la goutte Vo est de 100 µl.

Sur la figure 9, on a représenté les résultats pour des valeurs de RH_{∞} de 0 % (en traits pointillés) et de 40 % (en traits pleins).

### EXEMPLE 3

Dans cet exemple, on décrit l'obtention et la croissance d'un cristal de lysozyme de blanc d'oeuf de poule qui utilise l'appareil décrit plus haut.

On a choisi dans cet exemple le procédé par ensemencement, c'est-à-dire qu'un germe exogène ou cristal d'ensemencement est introduit dans la solution et qu'on réalise ensuite la croissance.

Les conditions expérimentales mises en oeuvre dans cet exemple sont les suivantes :
- températures T_{g} du gaz de sustentation et Tₚ de la paroi de l'enceinte constantes et égales à 20°C,
- hygrométrie relative de l'enceinte RH_{∞} maintenue constante à 100 %,
- composition et concentrations initiales en réactants dans la goutte : protéine 15 mg/ml, sel précipitant ClNa à une concentration 0,7 mol/l, concentration en acétate de sodium 25 mmol/l tamponnée pour pH 4,6,
- volume initial de la goutte 70 µl,
- dimension du germe introduit : environ 200 µm.

L'expérience a été arrêtée au bout de 28 heures. Le volume du cristal d'ensemencement du germe a augmenté d'environ 50 % comme cela a pu être montré par observation en microscopie optique (grossissement ∼ x 70) du cristal obtenu.

Ceci démontre que le bon ordre de grandeur a été atteint pour les conditions de croissance de cette protéine, et que, grâce à ce procédé, on pourra obtenir des cristaux en particulier de molécules organiques et/ou biologiques de taille, de forme et de qualité suffisantes pour réaliser l'étude de leur structure.

Le procédé selon l'invention ainsi que le dispositif pour sa mise en oeuvre, peuvent notamment être appliqués, selon les mêmes principes de fonctionnement dans deux domaines à finalités différentes. Le procédé selon l'invention peut ainsi être appliqué à l'étude de la structure de molécules organiques et/ou biologiques par des méthodes diffractométriques. La caractéristique déterminante du système étant dans ce cas la qualité de l'arrangement moléculaire obtenu grâce aux spécificités de l'élaboration sans contact.

Le procédé selon l'invention peut être utilisé comme technique séparative par cristallisation fractionnée pour l'obtention de quantités significatives d'une molécule déterminée, la caractéristique déterminante du système étant dans ce cas le volume relativement important de solution traitée comparativement à d'autres procédés de traitement sans contact.

## Revendications

1. Procédé d'élaboration d'au moins un cristal caractérisé en ce que ledit cristal est élaboré dans un milieu mis en sustentation sur un film de gaz.

2. Procédé selon la revendication 1, caractérisé en ce que le milieu mis en sustentation est une masse fluide ou gélifiée.

3. Procédé selon la revendication 2, caractérisé en ce que le milieu est une solution.

4. Procédé selon la revendication 2, caractérisé en ce que le milieu a la forme d'une goutte.

5. Procédé selon la revendication 1, caractérisé en ce que le composé dont on souhaite élaborer au moins un cristal est un composé organique ou minéral.

6. Procédé selon la revendication 1, caractérisé en ce que ledit composé est une macromolécule organique et/ou biologique.

7. Procédé selon la revendication 6, caractérisé en ce que ledit composé est une protéine.

8. Procédé selon la revendication 1, caractérisé en ce que le cristal est élaboré par nucléation d'un germe à partir du milieu de départ suivi de la croissance de ce germe jusqu'à obtention d'un cristal présentant la taille souhaitée.

9. Procédé selon la revendication 1, caractérisé en ce que le cristal est élaboré par ensemencement du milieu par un germe exogène, puis croissance jusqu'à obtention d'un cristal présentant la taille souhaitée.

10. Procédé selon la revendication 1, caractérisé en ce que le processus d'élaboration est maîtrisé en agissant sur au moins l'un des paramètres choisi parmi le débit de gaz de sustentation, l'hygrométrie relative et la température du gaz de sustentation, la température du milieu mis en sustentation et l'hygrométrie relative à la surface du milieu mis en sustentation, la température et l'hygrométrie relative dans l'enceinte où l'on réalise l'élaboration du cristal loin du milieu mis en sustentation, la température de la paroi de ladite enceinte.

11. Procédé selon la revendication 3, caractérisé en ce que le milieu mis en sustentation comprend en outre un composé précipitant.

12. Procédé selon la revendication 3, caractérisé en ce que le milieu comprend en outre un tampon de réglage du pH.

13. Procédé selon la revendication 1, caractérisé en ce que plusieurs milieux sont mis simultanément en sustentation moyennant quoi plusieurs cristaux sont simultanément élaborés.
